# EUROPEAN PATENT APPLICATION

(11) **EP 4 432 343 A1**
(43) Date of publication of application: **18.09.2024**
(21) Application number: 23205697.8
(22) Date of filing: 25.10.2023
(51) Int. Cl.: H01L 23/15, H01L 23/498

(54) **VIA STRUCTURES IN BONDED GLASS SUBSTRATES**

(30) Priority: 14.03.2023 US 202318121264
(71) Applicant: Intel Corporation, Santa Clara, CA 95054 (US)
(72) Inventor: KANDANUR, Sashi, Phoenix, 85048 (US); PIETAMBARAM, Srinivas, Chandler, 85249 (US); GRUJICIC, Darko, Chandler, 85249 (US); MARIN, Brandon, Gilbert, 85234 (US); NAD, Suddhasattwa, Chandler, 85249 (US); DUONG, Benjamin, Phoenix, 85044 (US); DUAN, Gang, Chandler, 85248 (US); RAHMAN, Mohammad, Gilbert, 85298 (US); AHMED, Numair, Chandler, 85286 (US)
(74) Representative: Goddar, Heinz J.

(57) **Abstract**

Embodiments herein relate to systems, apparatuses, techniques and/or processes for creating a substrate out of a plurality of layers of glass, where the substrate includes one or more vias that extend through each of the plurality of layers of glass. In embodiments, a high aspect ratio via may be constructed through the substrate by electrically coupling the individual vias. Other embodiments may be described and/or claimed.

## Description

### FIELD

Embodiments of the present disclosure generally relate to the field of package assemblies, and in particular package assemblies that include glass cores.

### BACKGROUND

High performance electronic devices are driving the need for heterogeneous integration of chips through advanced packaging. The resulting warpage and dimensional accuracy requirements on the package substrate may result in using glass cores substrates in packages.

### BRIEF DESCRIPTION OF THE DRAWINGS

FIG. 1 illustrates cross-section side views and a cross-section image of a substrate with a plurality of layers of glass, in accordance with various embodiments.
FIG. 2 illustrates cross-section side views of two layers of glass that include vias, where the layers of glass are bonded with each other to form a substrate with vias extending through the substrate, in accordance with various embodiments.
FIGs. 3A-3H illustrate stages in a manufacturing process for forming a substrate with multiple layers of glass that include vias filled with copper that extend through the substrate, in accordance with various embodiments.
FIG. 4 illustrates cross-section side views of two layers of glass that include vias with a polymeric material, where the layers of glass are bonded with each other to form a substrate with a via extending through the substrate, in accordance with various embodiments.
FIGs. 5A-5I illustrate stages in a manufacturing process for forming a substrate with multiple layers of glass that include vias filled with copper and with a polymeric material that may at least partially extend through the substrate, in accordance with various embodiments.
FIG. 6 illustrates an example of a process for creating a substrate with multiple layers of glass that include vias, where the layers of glass are bonded together to form a substrate with vias extending through the substrate, in accordance with various embodiments.
FIG. 7 illustrates cross-section side views of two layers of glass that include vias that have an opposite taper from each other, where the layers of glass are bonded with each other to form a substrate with a via extending through the substrate, in accordance with various embodiments.
FIGs. 8A-8H illustrate stages in a manufacturing process for forming a substrate with multiple layers of glass that include vias with opposite tapers filled with copper that extend through the substrate, in accordance with various embodiments.
FIG. 9 illustrates an example of a process for creating a substrate with multiple layers of glass that include vias that have an opposite taper from each other, where the layers of glass are bonded together to form a substrate with vias extending through the substrate, in accordance with various embodiments.
FIG. 10 illustrates examples of laser-assisted etching of glass interconnects processes, in accordance with various embodiments.
FIG. 11 schematically illustrates a computing device, in accordance with embodiments.

### DETAILED DESCRIPTION

Embodiments of the present disclosure may generally relate to systems, apparatus, and/or processes directed to forming a substrate out of a plurality of layers of glass, where the substrate includes one or more vias that extend through each of the plurality of layers of glass. In embodiments, when the plurality of layers of glass are combined to form a substrate, each of the one or more vias may be conductively coupled with each other. As a result, a high aspect ratio via may be constructed through the substrate by bonding the layers of glass so that the individual vias are conductively coupled.

Using layers of glass within substrates or interposers, or using layers of glass in a core of a substrate, may provide thermal and dimensional stability that enables finer laser via and lithographic critical dimensions. Embodiments may also provide better coplanarity and a reduction in total thickness variation as compared to organic alternatives. In addition, using layers of glass within a substrate may also allow for integration of optical transmission structures within the substrate.

In embodiments, each via may be filled with electrically conductive material such as copper, aluminum, or some other material. In embodiments, a polymeric material, which may serve a functional purpose, such as a component of an inductor or to be used to fill space within the via, may also be included within the vias in the plurality of layers of glass. In embodiments, inserting a polymeric material into a via may be referred to as a polymeric plug. In embodiments, vias that may be filled with electrically conductive material may be used to transmit either signals or power through the substrate.

In embodiments, the vias may be referred to as through glass vias (TGV), and may be formed using a variety of techniques, including laser through hole (LTH) techniques described herein. Using LTH techniques, high aspect ratio holes may be created for the vias in thin to medium-sized thickness glass substrates, for example vias having a length to diameter ratio of the 4:1. However, for longer vias through thicker glass substrates, for example 6:1, 8:1, 20: 1 or greater, legacy LTH techniques may have some challenges. In particular, the resulting holes for the vias may have an aspect ratio with a diameter that is too small for legacy full-volume copper metallization processes to completely fill. In addition, legacy polymeric plug techniques may also not reliably fill polymers in these high aspect ratio holes.

In addition, the LTH techniques used to create high aspect ratio holes may result in a hole where the middle of the hole is narrower in diameter than the top and/or the bottom of the hole. The resulting narrower middle diameter will result in a lower copper area in the middle section when filled, which may limit the current carrying capacity of the resulting via and hence limit the electrical functionality of the via through the substrate.

In embodiments described herein, techniques may be used that create a glass substrate from a plurality of layers of glass, where LTH techniques may be used to form holes in each of the plurality of layers of glass. In embodiments, each of the layers of glass may have a thickness that is selected such that an aspect ratio of a hole or via is 4:1 or less. An aspect ratio that is 4:1 or less may be referred to as a lower-moderate aspect ratio. In some embodiments, the thickness of one of the layers of glass may be 200 µm or less, and a diameter of a whole may be 50 µm or less. In embodiments, these techniques may be used for wafers that may be 300 mm in diameter or for panels with a form factor at 510 mm x 515 mm.

In embodiments, the holes formed in the plurality of layers of glass may then be filled with an electrically conductive material, or another material such as a polymeric material. Subsequently, the plurality of layers of glass may be bonded to each other such that the holes in each of the layers align, for example, to electrically couple the electrically conductive material in each of the holes in the layer of glass above and/or below. In embodiments where the LTH techniques result in a taper in a resulting hole in two layers of glass, one of the layers may be flipped after being filled with copper before bonding, so that the larger tapers of each via will be direct coupled with each other within the resulting substrate to facilitate an electrical connection after bonding.

In embodiments, the layers of glass may be bonded with each other using a variety of techniques, including direct and/or hybrid bonding techniques. In embodiments, the hybrid bonding techniques may include direct bonding of copper to copper in the layers of glass, and may include direct bonding of glass to glass. In embodiments, hybrid bonding and/or direct bonding techniques may be used to bond features or materials in adjacent layers of glass to each other while the substrate is being formed. When directly bonded together, two conductive features, structures or elements (e.g., two copper vias) may be described as "directly conductively coupled" meaning that there is no substantive intervening feature, structure, or element conductively coupling between the two features, structures or elements.

Embodiments described herein may facilitate stacking multiple moderate aspect ratio substrates to create a high aspect ratio substrate, or the moderate aspect ratio substrate may be a layer of glass. These embodiments may greatly reduce the need for capital expensive laser through hole plating equipment and/or development of exotic, non-scalable plating chemistries or polymeric materials, and will facilitate cost-effective architectures for client, desktop, server, switch, and/or optical products using high aspect ratio substrates with high density vias for power and/or signal routing.

In the following detailed description, reference is made to the accompanying drawings which form a part hereof, wherein like numerals designate like parts throughout, and in which is shown by way of illustration embodiments in which the subject matter of the present disclosure may be practiced. It is to be understood that other embodiments may be utilized and structural or logical changes may be made without departing from the scope of the present disclosure. Therefore, the following detailed description is not to be taken in a limiting sense, and the scope of embodiments is defined by the appended claims and their equivalents.

For the purposes of the present disclosure, the phrase "A and/or B" means (A), (B), or (A and B). For the purposes of the present disclosure, the phrase "A, B, and/or C" means (A), (B), (C), (A and B), (A and C), (B and C), or (A, B and C).

The description may use perspective-based descriptions such as top/bottom, in/out, over/under, and the like. Such descriptions are merely used to facilitate the discussion and are not intended to restrict the application of embodiments described herein to any particular orientation.

The description may use the phrases "in an embodiment," or "in embodiments," which may each refer to one or more of the same or different embodiments. Furthermore, the terms "comprising," "including," "having," and the like, as used with respect to embodiments of the present disclosure, are synonymous.

The term "coupled with," along with its derivatives, may be used herein. "Coupled" may mean one or more of the following. "Coupled" may mean that two or more elements are in direct physical or electrical contact. However, "coupled" may also mean that two or more elements indirectly contact each other, but yet still cooperate or interact with each other, and may mean that one or more other elements are coupled or connected between the elements that are said to be coupled with each other. The term "directly coupled" may mean that two or more elements are in direct contact. Further, the term "directly conductively coupled" means that two or more elements are coupled such that current may flow directly between two elements without passing through a third element.

Various operations may be described as multiple discrete operations in turn, in a manner that is most helpful in understanding the claimed subject matter. However, the order of description should not be construed as to imply that these operations are necessarily order dependent.

As used herein, the term "module" may refer to, be part of, or include an ASIC, an electronic circuit, a processor (shared, dedicated, or group) and/or memory (shared, dedicated, or group) that execute one or more software or firmware programs, a combinational logic circuit, and/or other suitable components that provide the described functionality.

Various Figures herein may depict one or more layers of one or more package assemblies. The layers depicted herein are depicted as examples of relative positions of the layers of the different package assemblies. The layers are depicted for the purposes of explanation, and are not drawn to scale. Therefore, comparative sizes of layers should not be assumed from the Figures, and sizes, thicknesses, or dimensions may be assumed for some embodiments only where specifically indicated or discussed.

Various embodiments may include one or more articles of manufacture (e.g., non-transitory computer-readable media) having instructions, stored thereon, that when executed result in actions of any of the above-described embodiments. Moreover, some embodiments may include apparatuses or systems having any suitable means for carrying out the various operations of the above-described embodiments.

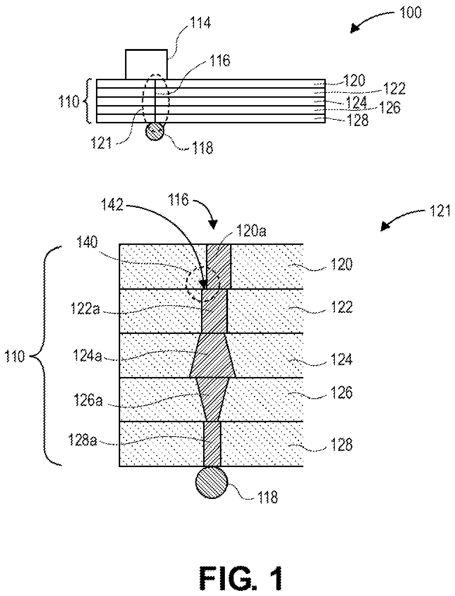

FIG. 1 illustrates cross-section side views and a cross-section diagram of an image of a substrate with a plurality of layers of glass, in accordance with various embodiments. Diagram 100 shows a cross-section side view of a package that includes a glass substrate 110 that is made up of five layers of glass 120, 122, 124, 126, 128 that are bonded with each other. A component 114, which may be, for example, an active component, a passive component, or a die, may be attached to a top of the glass substrate 110. A via 116, which may include an electrically conductive material such as copper or aluminum, may extend from the top of the glass substrate 110 to the bottom. In embodiments, the via 116 may also include a polymeric material. In embodiments, the via 116 may electrically couple the component 114 with an electrical connector 118. In embodiments, the electrical connector 118 may be a portion of a ball grid array (BGA).

In embodiments, the via 116 may pass through each of the layers of glass 120, 122, 124, 126, 128, as shown within area 121. Diagram 121 is an explosion of area 121, and includes the layers of glass 120, 122, 124, 126, 128. The via 116 may be made up of a series of via segments, in particular via 120a of layer of glass 120, via 122a of layer of glass 122, via 124a of layer of glass 124, via 126a of layer of glass 126, and via 128a of layer of glass 128. In embodiments, one or more of the vias 120a, 122a, 124a, 126a, 128a, while conductively coupledconductively coupled with each other, may be staggered due to misalignments when the layers of glass 120, 122, 124, 126, 128 are bonded together to form substrate 110.

For example, area 140 of diagram 121 shows a layer of glass 120 on top of layer of glass 122, but with a portion of the via 122a offset from a portion of the via 120a. This leaves an overlap 142 where the layer of glass 120 comes into direct contact with the portion of the via 122a. This overlap 142, as well as other offsets described herein, may result from the bonding process, which may include hybrid bonding or direct bonding, between the various layers of glass 120, 122, 124, 126, 128.

Returning to diagram 121, tapered vias, for example vias 124a, 126a, are shown where the LTH techniques used to create holes for the vias 124a, 126a produce a tapering. In embodiments, the layer of glass 124 or 126 were flipped prior to bonding with each other, so that the two non-tapered ends of the vias 124a, 126a are physically and conductively coupled with each other. In embodiments, this may facilitate a strong electrical connection between the vias 124a, 126a by maximizing the surface area of the connection between the two non-tapered ends of the vias 124a, 126a. It should be appreciated that any of the vias 120a, 122a, 124a, 126a, and 128a may have sides that are at an angle, and that may not be necessarily perpendicular to a plane of their respective glass substrates 120, 122, 124, 126, 128.

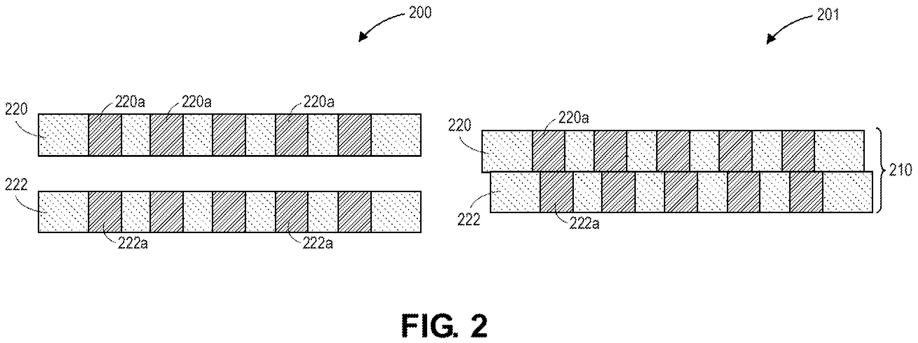

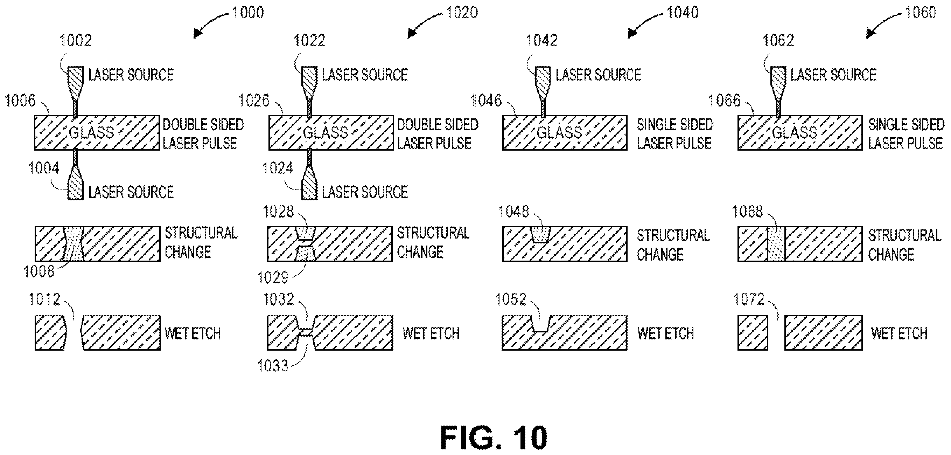

FIG. 2 illustrates cross-section side views of two layers of glass that include vias, where the layers of glass are bonded with each other to form a substrate with vias extending through the substrate, in accordance with various embodiments. Diagram 200 shows a first layer of glass 220 and a second layer of glass 222, which may be similar to layer of glass 120 and layer of glass 122 of FIG. 1. A plurality of vias 220a may be formed within the first layer of glass 220, and another plurality of vias 222a may be formed within the second layer of glass 222. Vias 220a may be similar to via 120a and vias 222a may be similar to via 122a of FIG. 1. In embodiments, the holes in the glass 220, 222 that are used to create vias 220a, 222a may be formed using the techniques described herein, and in particular with respect to FIG. 10.

Diagram 201 shows substrate 210, which may be similar to substrate 110 of FIG. 1, where the layer of glass 220 and the layer of glass 222 are bonded together. In embodiments, as described further below, this bonding may be accomplished through a hybrid bonding process, which may involve direct bonding the vias 220a with the vias 222a and direct bonding the exposed layer of glass 220 with the exposed layer of glass 222. In embodiments, the vias 220a, 222a may be filled with an electrically conductive metal such as copper, or may be filled with other substances, such as an electrically conductive material and a polymer.

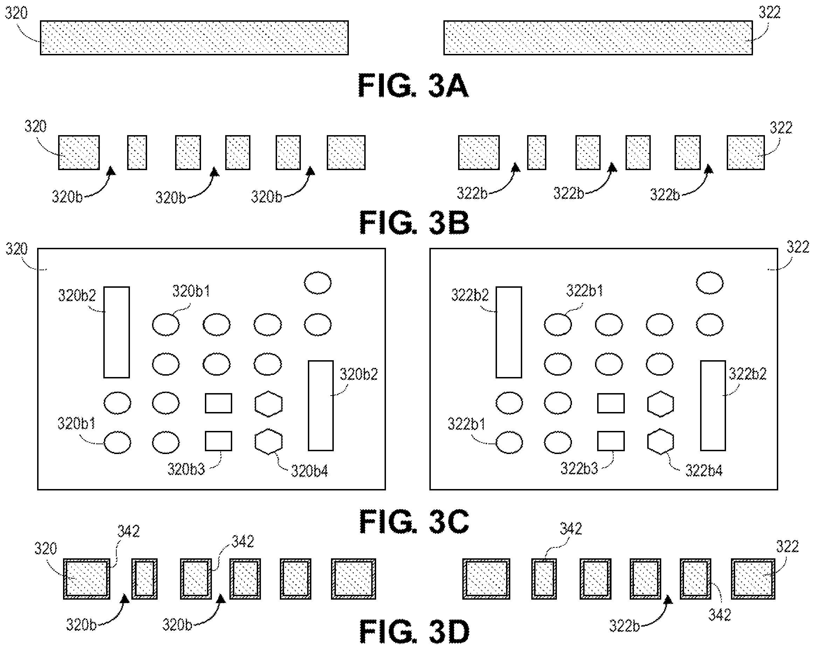

FIGs. 3A-3H illustrate stages in a manufacturing process for forming a substrate with multiple layers of glass that include vias filled with copper that extend through the substrate, in accordance with various embodiments. FIG. 3A illustrates cross-section side view of a stage in the manufacturing process where a first layer of glass 320 and the second layer of glass 322 are provided. In embodiments, the first layer of glass 320 and the second layer of glass 322 may have a thickness that is selected based upon a resulting aspect ratio of resulting holes drilled into the layers of being 4:1 or less. In embodiments, a thickness of the first layer of glass 320 or the second layer of glass 322 may be on the order of 200 µm or less.

FIG. 3B illustrates a cross-section side view of a stage in the manufacturing process where holes 320b may be formed within the first layer of glass 320, and holes 322b may be formed within the second layer of glass 322. In embodiments the holes 320b, 322b may be formed using a laser exposure process followed by wet chemical based development process, as described in more detail with respect to FIG. 10. Note that at the alignment of least some of the holes 320b should be configured with respect to the alignment of at least some of the holes 322b so that after bonding the first layer of glass 320 with the second layer of glass 322 that at least some of the holes 320b, 322b will be at least partially aligned.

FIG. 3C shows a top-down view of a stage in the manufacturing process that shows examples of holes 320b in the first layer of glass 320, and holes 322b in the second layer of glass 322 FIG. 3B. For the first layer of glass 320, holes 320b1 may be a circular or elliptical shape, holes 320b2 may be a rectangular or an oblong shape, holes 320b3 may be a square shape, or holes 320b4 may be a polygonal shape. In other embodiments, holes 320b may take some other shape. Similarly, for the second layer of glass 322, holes 322b1 may be a circular or elliptical shape, holes 322b2 may be a rectangular or an oblong shape, holes 322b3 may be a square shape, or holes 322b4 may be a polygonal shape. In other embodiments, holes 322b may take some other shape. In embodiments, the holes may have a diameter on the order of 50 µm.

FIG. 3D illustrates a cross-section side view of a stage in the manufacturing process where a copper seed 342 is placed on the first layer of glass 320 and the second layer of glass 322, and on the sides of the holes 320b, 322b. In embodiments, the copper seed 342 may be deposited using a physical vapor deposition (PVD) process.

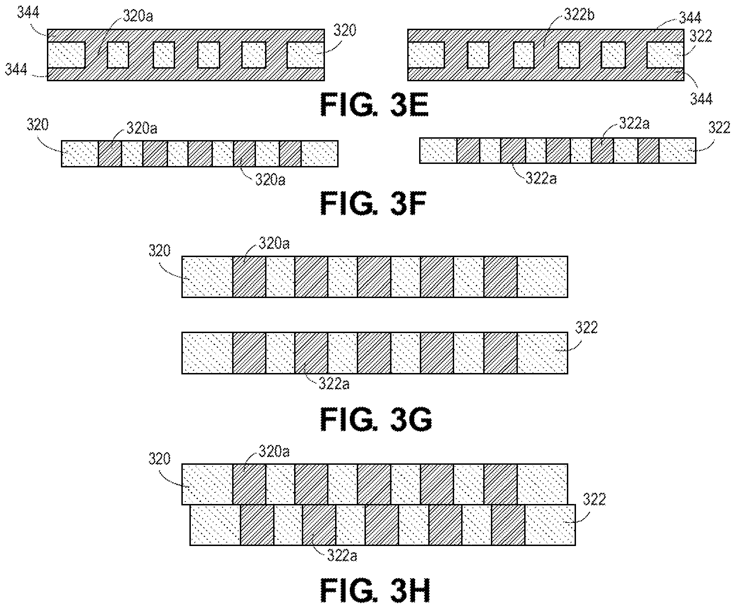

FIG. 3E illustrates a cross-section side view of a stage in the manufacturing process where a copper plating process may be applied to electrolytically plate copper 344. The copper 344 may be plated on the first layer of glass 320 and on the second layer of glass 322, and within the holes 320b, 322b of FIG. 3D, forming vias 320a within the first layer of glass 320 and forming vias 322a within the second layer of glass 322. In embodiments, vias 320a may be similar to vias 220a, and vias 322a may be similar to vias 222a of FIG. 2. In some embodiments, a plasma clean may be performed prior to the copper plating. Note that due to the thickness of the first layer of glass 320 and the second layer of glass 322, which in some embodiments may be on the order of 200 µm, the vias 320a, 322a may be completely filled with copper.

FIG. 3F illustrates a cross-section side view of a stage in the manufacturing process where a polishing process may be applied to remove excess copper 344 of FIG. 3E that may be above or below the first layer of glass 320 and the second layer of glass 322. In embodiments, this polishing process may include a chemical mechanical polishing (CMP). In some embodiments, an annealing process may be applied before the polishing process, to stabilize the copper grain structure. As a result, a first side and a second side of the first layer of glass 320, as well as a first side and a second side of the second layer of glass 322, are exposed. In addition, vias 320a and 322a are exposed for direct bonding.

FIG. 3G illustrates a cross-section side view of a stage in the manufacturing process where the first layer of glass 320 and the second layer of glass 322 are aligned prior to bonding. In embodiments, one or more of the vias 320a may be aligned with one or more of the vias 322a.

FIG. 3H illustrates a cross-section side view of a stage in the manufacturing process where the first layer of glass 320 and the second layer of glass 322 are bonded with each other. In embodiments, this bonding may be a hybrid bonding process. In other embodiments, one or more of the vias 320a may be direct bonded to one or more of the vias 322a. In embodiments, the first layer of glass 320 may be direct bonded to the second layer of glass 322. Note that in embodiments, the vias 320a and vias 322a may not be perfectly aligned, and may be slightly offset to placement errors of the first layer of glass 320 on the second layer of glass 322.

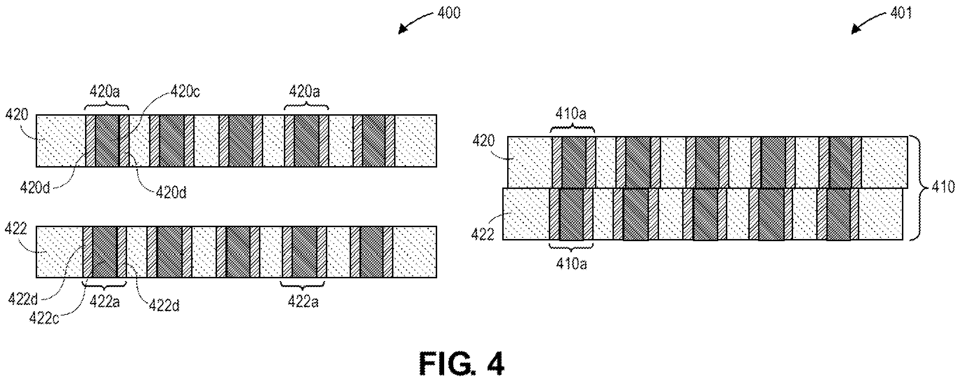

FIG. 4 illustrates cross-section side views of two layers of glass that include vias with a polymeric material, where the layers of glass are bonded with each other to form a substrate with a via extending through the substrate, in accordance with various embodiments. Diagram 400 shows a first layer of glass 420 and a second layer of glass 422, which may be similar to layer of glass 120 and layer of glass 122 of FIG. 1. A plurality of vias 420a may be formed within the first layer of glass 420, and another plurality of vias 422a may be formed within the second layer of glass 422. Vias 420a may be similar to via 120a and vias 422a may be similar to via 122a of FIG. 1. In embodiments, the vias 420a, 422a may be formed using the techniques described herein, and in particular with respect to FIG. 10.

Via 420a may include a polymeric material 420c that may be at least partially surrounded by a wall of electrically conductive material 420d. In embodiments, the wall of electrically conductive material 420d may include copper, aluminum, or some other electrically conductive material. Similarly, via 422a may include a polymeric material 422c that may be at least partially surrounded by a wall of electrically conductive material 422d. In embodiments, the wall of electrically conductive material 422d may include copper, aluminum, or some other electrically conductive material. In embodiments, the polymeric material 420c may be similar to the polymeric material 422c, and the electrically conductive material 420d may be similar to electrically conductive material 422d.

Diagram 401 shows substrate 410, which may be similar to substrate 110 of FIG. 1, where the layer of glass 420 and the layer of glass 422 have been bonded together. In embodiments, as described further below, this bonding may be accomplished through a hybrid bonding process, which may involve direct bonding the electrically conductive material 420d with the electrically conductive material 422d, direct bonding the polymeric material 420c with a polymeric material 422c, and/or direct bonding the layer of glass 420 with the layer of glass 422. As a result, one or more resulting vias 410a may be formed, combining the vias 420a with the vias 422a.

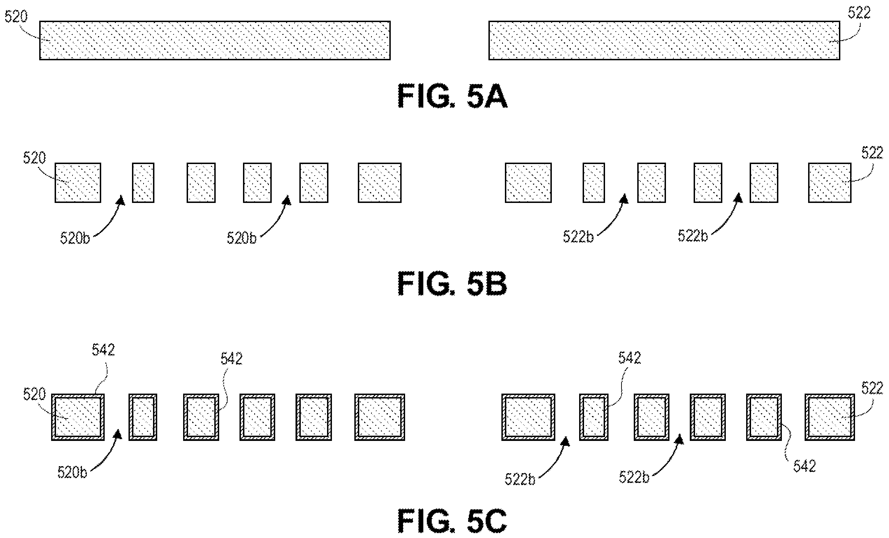

FIGs. 5A-5I illustrate stages in a manufacturing process for forming a substrate with multiple layers of glass that include vias filled with copper and with a polymeric material that may at least partially extend through the substrate, in accordance with various embodiments. FIG. 5A illustrates cross-section side view of a stage in the manufacturing process where a first layer of glass 520 and the second layer of glass 522 are provided, which may be similar to layers of glass 120, 122 of FIG. 1. In embodiments, the first layer of glass 520 and the second layer of glass 522 may have a same or a different thickness. In embodiments, the thickness of the layers of glass 520, 522 may be selected based upon a resulting aspect ratio of holes drilled into the layers of being 4:1 or less. In embodiments, a thickness of the first layer of glass 520 or the second layer of glass 522 may be on the order of 200 µm or less.

FIG. 5B illustrates a cross-section side view of a stage in the manufacturing process where holes 520b may be formed within the first layer of glass 520, and holes 522b may be formed within the second layer of glass 522. In embodiments the holes 520b, 522b may be formed using a laser exposure process followed by wet chemical-based development process, as described in more detail with respect to FIG. 10. Note that at least some of the holes 520b should at least partially align with the holes 522b, so that after bonding the first layer of glass 520 with the second layer of glass 522 that at least some of the holes 520b, 522b will be at least partially aligned with each other.

FIG. 5C illustrates a cross-section side view of a stage in the manufacturing process where a copper seed 542 is placed on the first layer of glass 520 and on the second layer of glass 522, and on the sides of the holes 520b, 522b. In embodiments, the copper seed 342 may be deposited using a PVD process.

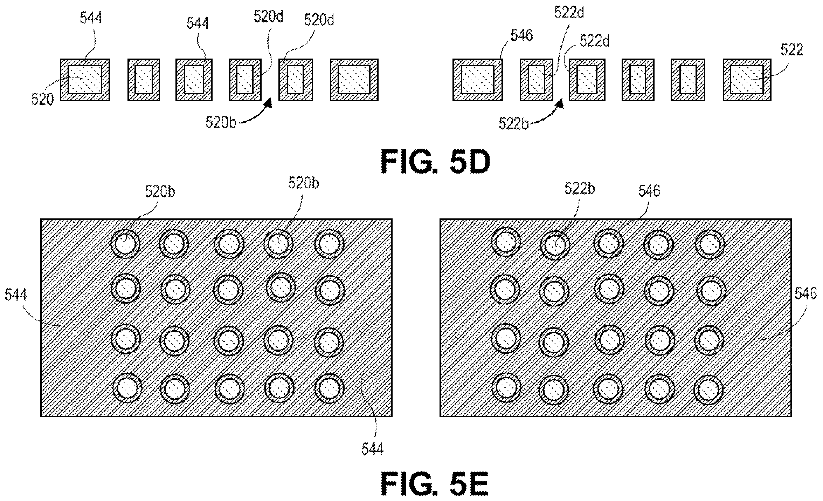

FIG. 5D illustrates a cross-section side view of a stage in the manufacturing process where a copper plating process may be applied to electrolytically plate copper 544, 546. The copper 544 may be plated on the first layer of glass 520. In embodiments, the copper 544 may also be plated on the sides of the holes 520b, forming electrically conductive material 520d on the sides of the holes 520b of FIGs. 5C-5D. In embodiments, the copper 544 may also be plated on the bottom of the layer of glass 520. Similarly, in embodiments the copper 546 may be plated on the second layer of glass 522. In embodiments, the copper 546 may also be plated on the sides of the holes 522b of FIGs. 5C-5D, forming electrically conductive material 522d on the sides of the holes 522b. In embodiments, the copper 546 may also be plated on the bottom of the layer of glass 522.

In embodiments, this process may form a wall of electrically conductive material 520d on the sides of the holes 520b, and may form a wall of electrically conductive material 522d on the sides of the holes 522b. In embodiments, the wall of electrically conductive material 520d may be similar to the wall of electrically conductive material 420d and the wall of electrically conductive material 522d may be similar to the wall of electrically conductive material 422d of FIG. 4. In embodiments, the copper 544 and the copper 546 may be within a same layer and may be formed at a same time.

In some embodiments, a plasma clean may be performed prior to the copper plating. In embodiments, the copper plating process may be performed by a copper electroplating process, and a thickness of the wall of electrically conductive material 520d, 522d may be determined by varying a duration of time of the copper electroplating process.

FIG. 5E illustrates a top-down view of a stage in the manufacturing process of FIG. 5D that shows a top of the first layer of glass 520 and the second layer of glass 522, where the plated copper 544 surrounds the holes 520b and the plated copper 546 surrounds the holes 522b.

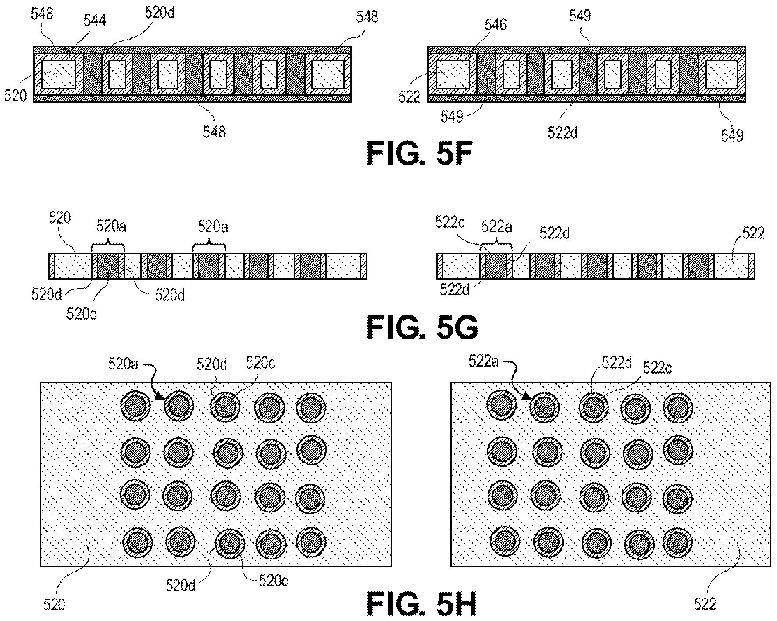

FIG. 5F illustrates a cross-section of a stage of the manufacturing process, which may be similar to FIG. 5D, where a polymer plugging process is applied to form a polymeric material 548 around the plated copper 544 and the wall of electrically conductive material 520d, and to form a polymeric material 549 around the plated copper 546 and the wall of electrically conductive material 522d.

FIG. 5G illustrates a cross-section of a stage of the manufacturing process, where a planarization process occurs on either side of the layer of glass 520 and on either side of the layer of glass 522. In embodiments, vias 520a may be formed in the layer of glass 520, where the vias 520a include a wall of electrically conductive material 520d surrounding or partially surrounding a polymeric material 520c that was formed in the stage depicted in FIG. 5F. Similarly, vias 522a may be formed in the layer of glass 522, where the vias 522a include a wall of electrically conductive material 522d surrounding or partially surrounding a polymeric material 522c that was formed in the stage depicted in FIG. 5F.

FIG. 5H illustrates a top-down view of the stage of the manufacturing process of FIG. 5G. In embodiments, the first layer of glass 520 includes a plurality of vias 520a, where the vias 520a include a polymeric material 520c that is surrounded by a wall of electrically conductive material 520d. In embodiments, the second layer of glass 522 includes a plurality of vias 522a, where the vias 522a include a polymeric material 522c that is surrounded by a wall of electrically conductive material 522d.

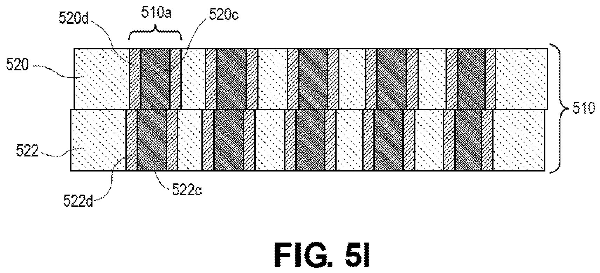

FIG. 5I illustrates a cross-section side view of a stage in the manufacturing process where the first layer of glass 520 of FIG. 5G and the second layer of glass 522 of FIG. 5G are bonded to each other, forming a substrate 510 that includes a via 510a, which may be similar to via 410a of FIG. 4. In embodiments, the wall of conductive material 520d may be physically and conductively coupled with the wall of conductive material 522d, and in embodiments, they may be direct and/or hybrid bonded. In embodiments, the polymeric material 520c may be bonded to the polymeric material 522c. In embodiments, they may also be direct bonded. In embodiments, the first layer of glass 520 may be bonded to the second layer of glass 522. In embodiments, they may also be direct bonded. In embodiments, a hybrid bonding process may be used to bond the first layer of glass 520 with the second layer of glass 522.

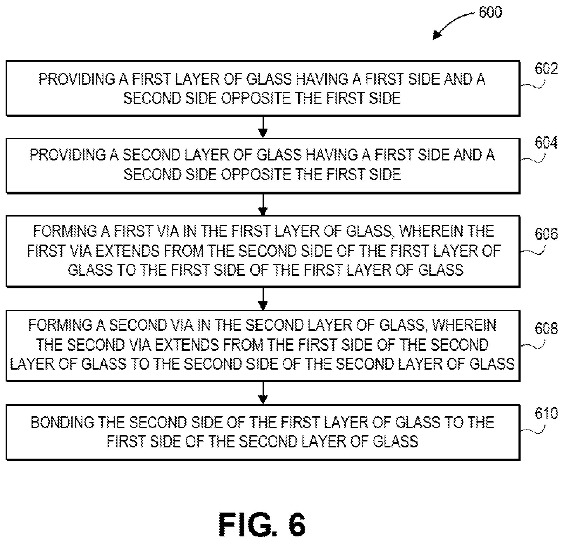

FIG. 6 illustrates an example of a process for creating a substrate with multiple layers of glass that include vias, where the layers of glass are bonded together to form a substrate with vias extending through the substrate, in accordance with various embodiments. Parts or all of process 600 may be performed by processes, techniques, systems, and/or apparatuses described herein, and in particular with respect to FIGs. 1-5I and 10.

At block 602, the process may include providing a first layer of glass having a first side and a second side opposite the first side. In embodiments, the first layer of glass may be similar to the first layer of glass 220 of FIG. 2 or to the first layer of glass 320 of FIG. 3A.

At block 604, the process may further include providing a second layer of glass having a first side and a second side opposite the first side. In embodiments, the second layer of glass may be similar to the second layer of glass 222 of FIG. 2 or to the second layer of glass 322 of FIG. 3A.

At block 606, the process may further include forming a first via in the first layer of glass, wherein the first via extends from the second side of the first layer of glass to the first side of the first layer of glass. In embodiments, the first via may be similar to the vias 220a of FIG. 2 , or to the vias 320a of FIGs 3G-3H.

At block 608, the process may further include forming a second via in the second layer of glass, wherein the second via extends from the first side of the second layer of glass to the second side of the second layer of glass. In embodiments, the first via may be similar to the vias 222a of FIG. 2, or to the vias 322a of FIGs. 3G-3H.

At block 610, the process may further include bonding the second side of the first layer of glass to the first side of the second layer of glass. In embodiments, the result of the bonding may be similar to substrate 210 of FIG. 2, or may be similar to FIG. 3H.

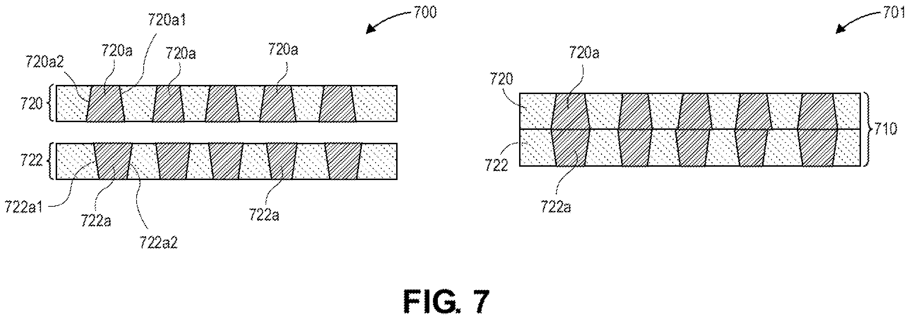

FIG. 7 illustrates cross-section side views of two layers of glass that include vias that have an opposite taper from each other, where the layers of glass are bonded with each other to form a substrate with a via extending through the substrate, in accordance with various embodiments. Diagram 700 shows a first layer of glass 720 and a second layer of glass 722, which may be similar to layer of glass 124 and layer of glass 126 of FIG. 1. A plurality of vias 720a may be formed within the first layer of glass 720, and another plurality of vias 722a may be formed within the second layer of glass 722. Vias 720a may be similar to via 124a and vias 722a may be similar to via 126a of FIG. 1.

In embodiments, the vias 720a, 722a may be formed using the techniques described herein, in particular using the LEGIT process discussed at least with respect to FIG. 10. Using this process, or other similar processes, may create tapers in the vias 720a, 722a. For example, a first side 720a1 and a second side 720a2 of a via 720a, may slope outward, and a first side 722a1 and a second side 722a2 of a via 722a may slope inward, with respect to the top of the vias 720a, 722a as shown. Note that as shown, the second layer of glass 722 may have been formed at the same time that the first layer of glass 720 was formed, with the second layer of glass 722 flipped after singulation in preparation for bonding with the first layer of glass 720.

Diagram 701 shows substrate 710, which may be similar to substrate 110 of FIG. 1, where the first layer of glass 720 and the second layer of glass 722 were bonded together. In embodiments, as described further below, this bonding may be accomplished through a hybrid bonding process, which may involve direct bonding the vias 720a with the vias 722a. In particular, the wider portion of the tapered vias 720a may be direct bonded to the wider portion of the tapered vias 722a, and the first layer of glass 720 may be bonded to the second layer of glass 722. In embodiments, a hybrid bonding process may be used.

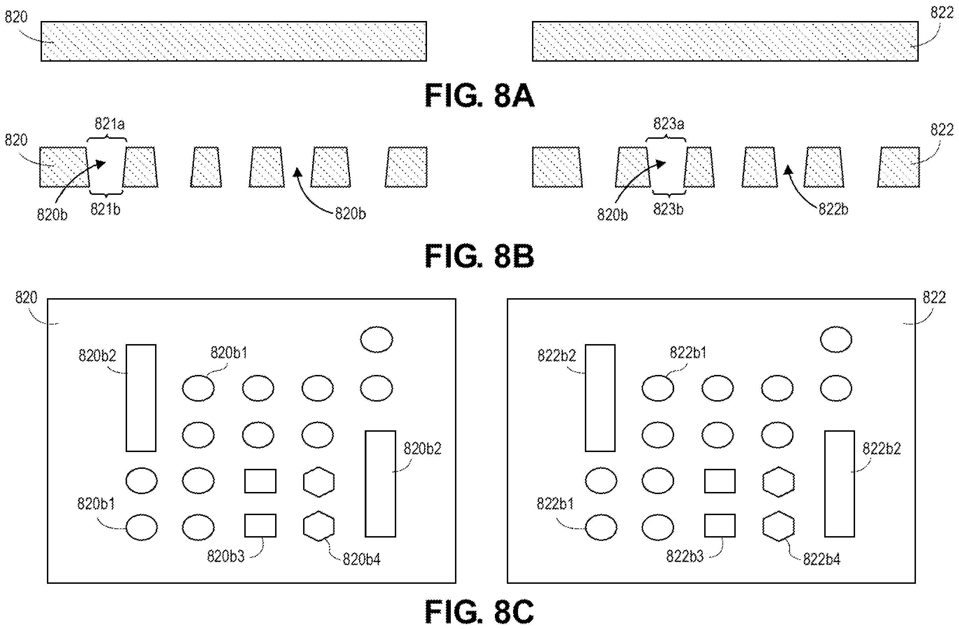

FIGs. 8A-8H illustrate stages in a manufacturing process for forming a substrate with multiple layers of glass that include vias with opposite tapers filled with copper that extend through the substrate, in accordance with various embodiments. FIG. 8A illustrates cross-section side view of a stage in the manufacturing process where a first layer of glass 820 and the second layer of glass 822 are provided. In embodiments, the first layer of glass 820 and the second layer of glass 822 may have a thickness that is selected based upon a resulting aspect ratio of resulting holes drilled into the layers of being 4:1 or less. In embodiments, a thickness of the first layer of glass 820 or the second layer of glass 822 may be on the order of 200 µm or less. In embodiments, the first layer of glass 820 may be similar to first layer of glass 720 and the second layer of glass 822 may be similar to the second layer of glass 722 of FIG. 7.

FIG. 8B illustrates a cross-section side view of a stage in the manufacturing process where holes 820b may be formed within the first layer of glass 820, and holes 822b may be formed within the second layer of glass 822. In embodiments the holes 820b, 822b may be formed using a laser exposure process followed by wet chemical based development process, as described in more detail with respect to FIG. 10. Note that due to this process, or other similar process, used to create the holes 820b, 822b, a taper in the holes 820b, 822b may result. In some embodiments, angles of the taper may range from 1-3°. In embodiments, a hole 820b with a first cross-section 821a at one side of the first layer of glass 820 may have a larger area than a second cross-section 821b at a second side of the first layer of glass 820 opposite the first side. In embodiments, one or more sides of the hole 820b may taper from the first cross-section 821a toward the second cross-section 821b.

Similarly, in embodiments, a hole 822b with a first cross-section 823a at one side of the first layer of glass 822 may have a larger area than a second cross-section 823b at the second side of the first layer of glass 822 opposite the first side. In embodiments, one or more sides of the hole 822b may taper from the first cross-section 823a toward the second cross-section 823b. Note that at least some of the holes 820b should at least partially aligned with the holes 822b so that after bonding the first layer of glass 820 with the second layer of glass 822 that at least some of the holes 820b, 822b will be at least partially aligned with each other.

FIG. 8C shows a top-down view of a stage in the manufacturing process that shows examples of holes 820b in first layer of glass 820, and holes 822b of second layer of glass 822 of FIG. 8B. For the first layer of glass 820, holes 820b1 may be a circular or elliptical shape, holes 820b2 may be a rectangular or an oblong shape, holes 820b3 may be a square shape, or holes 820b4 may be a polygonal shape. In other embodiments, holes 820b may take some other shape. Similarly, for the second layer of glass 822, holes 822b1 may be a circular or elliptical shape, holes 822b2 may be a rectangular or an oblong shape, holes 822b3 may be a square shape, or holes 822b4 may be a polygonal shape. In other embodiments, holes 822b may take some other shape. In embodiments, the holes may have a diameter on the order of 50 µm.

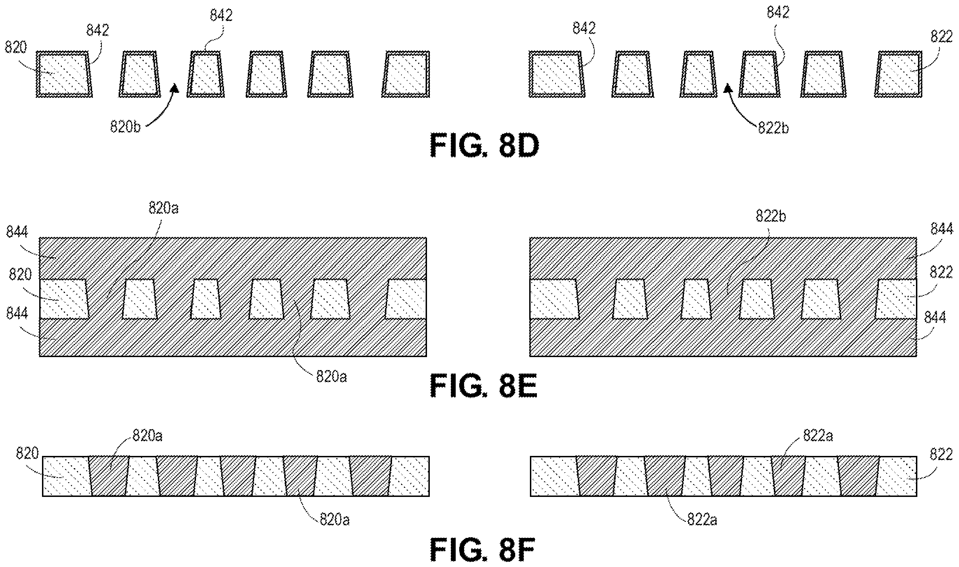

FIG. 8D illustrates a cross-section side view of a stage in the manufacturing process where a copper seed 842 is placed on the first layer of glass 820 and the second layer of glass 822, and on around the sides of the holes 820b, 822b. In embodiments, the copper seed 842 may be deposited using a physical vapor deposition (PVD) process

FIG. 8E illustrates a cross-section side view of a stage in the manufacturing process where a copper plating process may be applied to electrolytically plate copper 844. The copper 844 may be plated on the first layer of glass 820 and the second layer of glass 822, and within the holes 820b, 822b of FIG. 8D, forming vias 820a within first layer of glass 820 and forming vias 822a within second layer of glass 822. In embodiments, vias 820a may be similar to vias 320a, and vias 822a may be similar to vias 322a of FIG. 3E. In some embodiments, a plasma clean may be performed prior to the copper plating. Note that due to the thickness of the first layer of glass 820 and the second layer of glass 822, which in some embodiments may be on the order of 200 µm, the vias 820a, 822a may be completely filled with copper.

FIG. 8F illustrates a cross-section side view of a stage in the manufacturing process where a polishing process may be applied to remove excess copper 844 that may be above or below the first layer of glass 820 and the second layer of glass 822. In embodiments, this may be a chemical mechanical polishing (CMP) process. As a result, a first side and a second side of the first layer of glass 820, as well as a first side and a second side of the second layer of glass 822, are exposed. In addition, vias 820a and 822a are exposed for direct bonding.

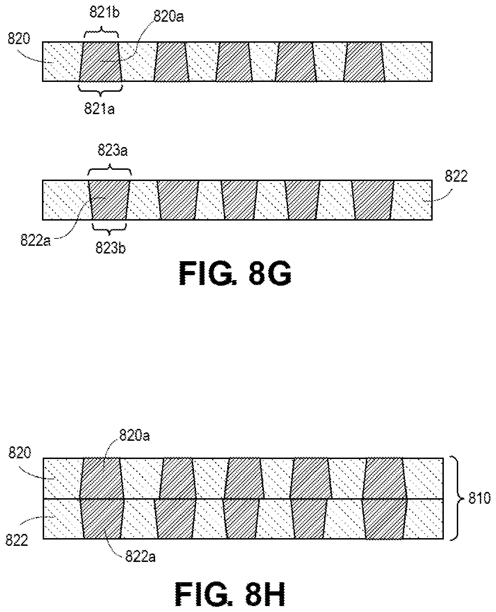

FIG. 8G illustrates a cross-section side view of a stage in the manufacturing process where the first layer of glass 820 and the second layer of glass 822 are aligned prior to bonding. In embodiments, one or more of the vias 820a may be aligned with one or more of the vias 822a. In embodiments, the first layer of glass 820 may be flipped so that the first cross-section 821a of the via 820a, which is larger than the second cross-section 821b, is aligned with the first cross-section 823a of the via 822a in the second layer of glass 822, which is larger than the second cross-section 823b.

FIG. 8H illustrates a cross-section side view of a stage in the manufacturing process, it shows substrate 810, which may be similar to substrate 110 of FIG. 1, where the first layer of glass 820 and the second layer of glass 822 are bonded. In embodiments, this bonding may be a hybrid bonding process. In other embodiments, one or more of the vias 820a may be direct bonded to one or more of the vias 822a. In embodiments, the first layer of glass 820 may be direct bonded to the second layer of glass 822.

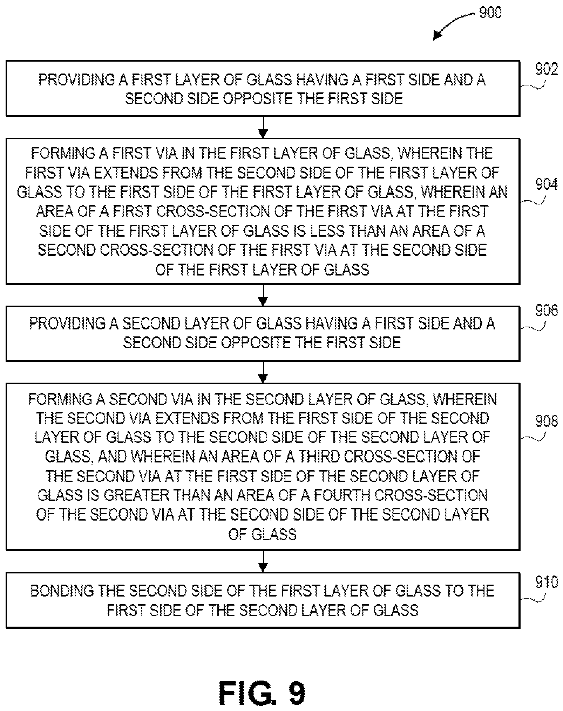

FIG. 9 illustrates an example of a process for creating a substrate with multiple layers of glass that include vias, where the layers of glass are bonded together to form a substrate with vias extending through the substrate, in accordance with various embodiments. In embodiments, process 900 may be performed using the processes, techniques, apparatus, and/or systems described herein, and in particular with respect to FIGs. 7-8H.

At block 902, the process may include providing a first layer of glass having a first side and a second side opposite the first side. In embodiments, the first layer of glass may be similar to the first layer of glass 720 of FIG. 7, or may be similar to the first layer of glass 820 of FIG. 8A.

At block 904, the process may further include forming a first via in the first layer of glass, wherein the first via extends from the second side of the first layer of glass to the first side of the first layer of glass, wherein an area, or a size, of a first cross-section of the first via at the first side of the first layer of glass is less than an area, or a size, of a second cross-section of the first via at the second side of the first layer of glass. In embodiments, the first via may be similar to first via 720a of FIG. 7, or may be similar to the first via 820a of FIG. 8F. In embodiments, the area, or a size, of the first cross-section of the first via at the first side of the first layer of glass may be similar to cross-section 821b, and the area, or a size, of the second cross-section of the first via at the second side of the first layer of glass may be similar to cross-section 821a of FIG. 8G.

At block 906, the process may further include providing a second layer of glass having a first side and a second side opposite the first side. In embodiments, the second layer of glass may be similar to the second layer of glass 722 of FIG. 7, or may be similar to the second layer of glass 822 of FIG. 8A.

At block 908, the process may further include forming a second via in the second layer of glass, wherein the second via extends from the first side of the second layer of glass to the second side of the second layer of glass, and wherein an area of a third cross-section of the second via at the first side of the second layer of glass is greater than an area of a fourth cross-section of the second via at the second side of the second layer of glass. In embodiments, the second via may be similar to second via 722a of FIG. 7, or may be similar to the second via 822a of FIG. 8F. In embodiments, the area of the third cross-section of the second via at the first side of the second layer of glass may be similar to cross-section 823a, and the area of the fourth cross-section of the second via at the second side of the second layer of glass may be similar to cross-section 821b of FIG. 8G

At block 910, the process may further include bonding the second side of the first layer of glass to the first side of the second layer of glass. In embodiments, the result of the bonding may be similar to substrate 710 of FIG. 7, or may be similar to substrate 810 of FIG. 8H.

FIG. 10 illustrates multiple examples of laser-assisted etching of glass interconnects processes, in accordance with embodiments. FIG. 10 illustrates multiple examples of laser-assisted etching of glass interconnects processes (which may be referred to as "LEGIT" herein), in accordance with embodiments. One use of the LEGIT technique is to provide an alternative substrate core material to the legacy copper clad laminate (CCL) core used in semiconductor packages used to implement products such as servers, graphics, clients, 5G, and the like. By using laser-assisted etching, crack free, high density via drills, hollow shapes may be formed into a glass substrate. In embodiments, different process parameters may be adjusted to achieve drills of various shapes and depths, thus opening the door for innovative devices, architectures, processes, and designs in glass. Embodiments, such as the bridge discussed herein, may also take advantage of these techniques.

Diagram 1000 shows a high level process flow for a through via and blind via (or trench) in a microelectronic package substrate (e.g. glass) using LEGIT to create a through via or a blind via. A resulting volume/shape of glass with laser-induced morphology change that can then be selectively etched to create a trench, a through hole or a void that can be filled with conductive material. A through via 1012 is created by laser pulses from two laser sources 1002, 1004 on opposite sides of a glass wafer 1006. As used herein, a through drill and a through via refers to when the drill or the via starts on one side of the glass/substrate and ends on the other side. A blind drill and a blind via refers to when the drill or the via starts on the surface of the substrate and stops half way inside the substrate. In embodiments, the laser pulses from the two laser sources 1002, 1004 are applied perpendicularly to the glass wafer 1006 to induce a morphological change 1008, which may also be referred to as a structural change, in the glass that encounters the laser pulses. This morphological change 1008 includes changes in the molecular structure of the glass to make it easier to etch out (remove a portion of the glass). In embodiments, a wet etch process may be used.

Diagram 1020 shows a high level process flow for a double blind shape. A double blind shape 1032, 1033 may be created by laser pulses from two laser sources 1022, 1024, which may be similar to laser sources 1002, 1004 that are on opposite sides of the glass wafer 1026, which may be similar to glass wafer 1006. In this example, adjustments may be made in the laser pulse energy and/or the laser pulse exposure time from the two laser sources 1022, 1024. As a result, morphological changes 1028, 1029 in the glass 1026 may result, with these changes making it easier to etch out portions of the glass. In embodiments, a wet etch process may be used.

Diagram 1040 shows a high level process flow for a single-blind shape, which may also be referred to as a trench. In this example, a single laser source 1042 delivers a laser pulse to the glass wafer 1046 to create a morphological change 1048 in the glass 1046. As described above, these morphological changes make it easier to etch out a portion of the glass 1052. In embodiments, a wet etch process may be used.

Diagram 1060 shows a high level process flow for a through via shape. In this example, a single laser source 1062 applies a laser pulse to the glass 1066 to create a morphological change 1068 in the glass 1066, with the change making it easier to etch out a portion of the glass 1072. As shown here, the laser pulse energy and/or laser pulse exposure time from the laser source 1062 has been adjusted to create an etched out portion 1072 that extends entirely through the glass 1066.

With respect to FIG. 10, although embodiments show laser sources 1002, 1004, 1022, 1024, 1042, 1062 as perpendicular to a surface of the glass 1006, 1026, 1046, 1066, in embodiments, the laser sources may be positioned at an angle to the surface of the glass, with pulse energy and/or pulse exposure time variations in order to cause a diagonal via or a trench, or to shape the via, such as 1012, 1072, for example to make it cylindrical, tapered, or include some other feature. In addition, varying the glass type may also cause different features within a via or a trench as the etching of glass is strongly dependent on the chemical composition of the glass.

In embodiments using the process described with respect to FIG. 10, through hole vias 1012, 1072 may be created that are less than 10 µm in diameter, and may have an aspect ratio of 40:1 to 50:1. As a result, a far higher density of vias may be placed within the glass and be placed closer to each other at a fine pitch. In embodiments, this pitch may be 50 µm or less. After creating the vias or trenches, a metallization process may be applied in order to create a conductive pathway through the vias or trenches, for example a plated through hole (PTH). Using these techniques, finer pitch vias will result in better signaling, allowing more I/O signals to be put through the glass wafer and to other coupled components such as a substrate.

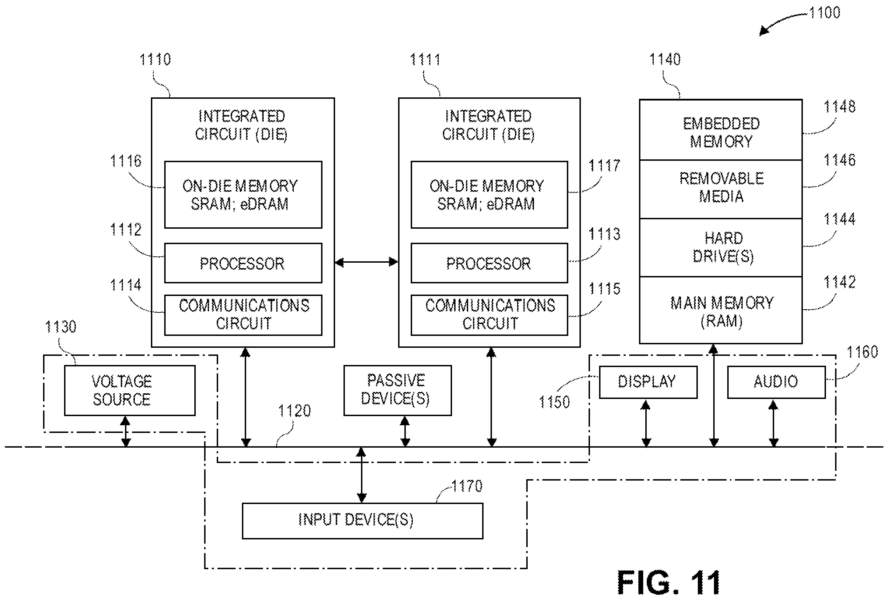

FIG. 11 is a schematic of a computer system 1100, in accordance with an embodiment of the present invention. The computer system 1100 (also referred to as the electronic system 1100) as depicted can embody via structures in bonded glass substrates, according to any of the several disclosed embodiments and their equivalents as set forth in this disclosure. The computer system 1100 may be a mobile device such as a netbook computer. The computer system 1100 may be a mobile device such as a wireless smart phone. The computer system 1100 may be a desktop computer. The computer system 1100 may be a handheld reader. The computer system 1100 may be a server system. The computer system 1100 may be a supercomputer or high-performance computing system.

In an embodiment, the electronic system 1100 is a computer system that includes a system bus 1120 to electrically couple the various components of the electronic system 1100. The system bus 1120 is a single bus or any combination of busses according to various embodiments. The electronic system 1100 includes a voltage source 1130 that provides power to the integrated circuit 1110. In some embodiments, the voltage source 1130 supplies current to the integrated circuit 1110 through the system bus 1120.

The integrated circuit 1110 is conductively coupled to the system bus 1120 and includes any circuit, or combination of circuits according to an embodiment. In an embodiment, the integrated circuit 1110 includes a processor 1112 that can be of any type. As used herein, the processor 1112 may mean any type of circuit such as, but not limited to, a microprocessor, a microcontroller, a graphics processor, a digital signal processor, or another processor. In an embodiment, the processor 1112 includes, or is coupled with, via structures in bonded glass substrates, as disclosed herein. In an embodiment, SRAM embodiments are found in memory caches of the processor. Other types of circuits that can be included in the integrated circuit 1110 are a custom circuit or an application-specific integrated circuit (ASIC), such as a communications circuit 1114 for use in wireless devices such as cellular telephones, smart phones, pagers, portable computers, two-way radios, and similar electronic systems, or a communications circuit for servers. In an embodiment, the integrated circuit 1110 includes on-die memory 1116 such as static random-access memory (SRAM). In an embodiment, the integrated circuit 1110 includes embedded on-die memory 1116 such as embedded dynamic random-access memory (eDRAM).

In an embodiment, the integrated circuit 1110 is complemented with a subsequent integrated circuit 1111. Useful embodiments include a dual processor 1113 and a dual communications circuit 1115 and dual on-die memory 1117 such as SRAM. In an embodiment, the dual integrated circuit 1110 includes embedded on-die memory 1117 such as eDRAM.

In an embodiment, the electronic system 1100 also includes an external memory 1140 that in turn may include one or more memory elements suitable to the particular application, such as a main memory 1142 in the form of RAM, one or more hard drives 1144, and/or one or more drives that handle removable media 1146, such as diskettes, compact disks (CDs), digital variable disks (DVDs), flash memory drives, and other removable media known in the art. The external memory 1140 may also be embedded memory 1148 such as the first die in a die stack, according to an embodiment.

In an embodiment, the electronic system 1100 also includes a display device 1150, an audio output 1160. In an embodiment, the electronic system 1100 includes an input device such as a controller 1170 that may be a keyboard, mouse, trackball, game controller, microphone, voice-recognition device, or any other input device that inputs information into the electronic system 1100. In an embodiment, an input device 1170 is a camera. In an embodiment, an input device 1170 is a digital sound recorder. In an embodiment, an input device 1170 is a camera and a digital sound recorder.

As shown herein, the integrated circuit 1110 can be implemented in a number of different embodiments, including a package substrate having via structures in bonded glass substrates, according to any of the several disclosed embodiments and their equivalents, an electronic system, a computer system, one or more methods of fabricating an integrated circuit, and one or more methods of fabricating an electronic assembly that includes a package substrate having via structures in bonded glass substrates, according to any of the several disclosed embodiments as set forth herein in the various embodiments and their art-recognized equivalents. The elements, materials, geometries, dimensions, and sequence of operations can all be varied to suit particular I/O coupling requirements including array contact count, array contact configuration for a microelectronic die embedded in a processor mounting substrate according to any of the several disclosed package substrates having via structures in bonded glass substrates embodiments and their equivalents. A foundation substrate may be included, as represented by the dashed line of FIG. 11. Passive devices may also be included, as is also depicted in FIG. 11.

Although certain embodiments have been illustrated and described herein for purposes of description, a wide variety of alternate and/or equivalent embodiments or implementations calculated to achieve the same purposes may be substituted for the embodiments shown and described without departing from the scope of the present disclosure. This application is intended to cover any adaptations or variations of the embodiments discussed herein. Therefore, it is manifestly intended that embodiments described herein be limited only by the claims.

Where the disclosure recites "a" or "a first" element or the equivalent thereof, such disclosure includes one or more such elements, neither requiring nor excluding two or more such elements. Further, ordinal indicators (e.g., first, second or third) for identified elements are used to distinguish between the elements, and do not indicate or imply a required or limited number of such elements, nor do they indicate a particular position or order of such elements unless otherwise specifically stated.

Various embodiments may include any suitable combination of the above-described embodiments including alternative (or) embodiments of embodiments that are described in conjunctive form (and) above (e.g., the "and" may be "and/or"). Furthermore, some embodiments may include one or more articles of manufacture (e.g., non-transitory computer-readable media) having instructions, stored thereon, that when executed result in actions of any of the above-described embodiments. Moreover, some embodiments may include apparatuses or systems having any suitable means for carrying out the various operations of the above-described embodiments.

The above description of illustrated embodiments, including what is described in the Abstract, is not intended to be exhaustive or to limit embodiments to the precise forms disclosed. While specific embodiments are described herein for illustrative purposes, various equivalent modifications are possible within the scope of the embodiments, as those skilled in the relevant art will recognize.

These modifications may be made to the embodiments in light of the above detailed description. The terms used in the following claims should not be construed to limit the embodiments to the specific implementations disclosed in the specification and the claims. Rather, the scope of the invention is to be determined entirely by the following claims, which are to be construed in accordance with established doctrines of claim interpretation.

### EXAMPLES

The following paragraphs describe examples of various embodiments.

Example 1 is a package comprising: a first layer of glass having a first side and a second side opposite the first side; a second layer of glass having a first side and a second side opposite the first side, wherein the second side of the first layer of glass is physically coupled with the first side of the second layer of glass; a first opening in the first layer of glass that extends from the second side of the first layer of glass to the first side of the first layer of glass, wherein the first opening includes a first conductive material; a second opening in the second layer of glass that extends from the first side of the second layer of glass to the second side of the second layer of glass, wherein the second opening includes a second electrically conductive material; and wherein the first electrically conductive material and the second electrically conductive material are directly conductively coupled with each other.

Example 2 includes the package of example 1, wherein a portion of a first cross-section of the first opening at the second side of the first layer of glass is offset from a second cross-section of the second opening at the first side of the second layer of glass.

Example 3 includes the package of example 2, wherein the first cross-section or the second cross-section is a selected one or more of: a circle, a polygon, or an irregular shape.

Example 4 includes the package of examples 1, 2, or 3, wherein the first electrically conductive material or the second conductive material includes a selected one or more of: copper (Cu), aluminum (Al), or gold (Au).

Example 5 includes the package of examples 1, 2, 3, or 4, wherein the first electrically conductive material fills the first opening and the second electrically conductive material fills the second opening.

Example 6 includes the package of examples 1, 2, 3, 4, or 5, further comprising a first material in the first opening, wherein the first material is at least partially surrounded by the first electrically conductive material, or a second material in the second opening, wherein the second material is at least partially surrounded by the second electrically conductive material.

Example 7 includes the package of example 6, wherein the first material or the second material is a polymeric material.

Example 8 includes the package of examples 1, 2, 3, 4, 5, 6, or 7, wherein the first electrically conductive material and the second conductive material are direct bonded to each other.

Example 9 includes the package of examples 1, 2, 3, 4, 5, 6, 7, or 8, wherein the first layer of glass is direct bonded to the second layer of glass.

Example 10 is a system comprising: an electrical component; a package coupled with the electrical component, the package comprising: a first layer of glass having a first side and a second side opposite the first side; a second layer of glass having a first side and a second side opposite the first side, wherein the second side of the first layer of glass is physically coupled with the first side of the second layer of glass; a first via that includes an electrically conductive material, wherein the first via extends from the second side of the first layer of glass to the first side of the first layer of glass; a second via that includes the electrically conductive material, wherein the second via extends from the first side of the second layer of glass to the second side of the second layer of glass, wherein the first via and the second via are conductively coupled with each other; and wherein a portion of a first cross-section of the first via at the second side of the first layer of glass is offset from a second cross-section of the second via at the first side of the second layer of glass.

Example 11 includes the system of example 10, wherein the electrically conductive material includes a selected one or more of copper or aluminum.

Example 12 includes the system of examples 10 or 11, further comprising: a first material in the first via, wherein the first material is at least partially surrounded by the electrically conductive material, or a second material in the second via, wherein the second material is at least partially surrounded by the electrically conductive material; and wherein the first material or the second material is a polymeric material.

Example 13 includes the system of examples 10, 11, or 12, wherein the first via and the second via are directly bonded to each other.

Example 14 includes the system of examples 10, 11, 12, or 13, further comprising: a third layer of glass having a first side and a second side opposite the first side, wherein the third layer of glass includes a third via filled with the electrically conductive material, wherein the third via extends from the first side of the third layer of glass to the second side of the third layer of glass; wherein the first side of the third layer of glass is directly coupled with the second side of the second layer of glass; and wherein the third via is directly conductively coupled with the second via.

Example 15 includes the system of example 14, wherein the first layer of glass is direct bonded to the second layer of glass, and wherein the second layer of glass is direct bonded to the third layer of glass.

Example 16 includes the system of examples 10, 11, 12, 13, 14, or 15, wherein the first via is direct bonded to the second via, and wherein the second via is direct bonded to the third via.

Example 17 is a method comprising: providing a first layer of glass having a first side and a second side opposite the first side; providing a second layer of glass having a first side and a second side opposite the first side; forming a first via in the first layer of glass, wherein the first via extends from the second side of the first layer of glass to the first side of the first layer of glass; forming a second via in the second layer of glass, wherein the second via extends from the first side of the second layer of glass to the second side of the second layer of glass; and bonding the second side of the first layer of glass to the first side of the second layer of glass.

Example 18 includes the method of example 17, wherein forming the first via in the first layer of glass further comprises filling the first via in the first layer of glass with an electrically conductive material; wherein forming the second via in the second layer of glass further comprises filling the second via in the second layer of glass with the electrically conductive material; and wherein bonding the second side of the first layer of glass to the first side of the second layer of glass further includes directly electrically coupling the filled first via with the filled second via.

Example 19 includes the method of example 18, wherein bonding the second side of the first layer of glass to the first side of the second layer of glass further includes direct bonding the first via and the second via.

Example 20 includes the method of examples 18 or 19, wherein the electrically conductive material includes a selected one or more of: copper or aluminum.

Example 21 is a package comprising: a first layer of glass having a first side and a second side opposite the first side; a second layer of glass having a first side and a second side opposite the first side, wherein the second side of the first layer of glass is physically coupled with the first side of the second layer of glass; a first opening in the first layer of glass that extends from the second side of the first layer of glass to the first side of the first layer of glass, wherein an area of a first cross-section of the first opening at the first side of the first layer of glass is less than an area of a second cross-section of the first opening at the second side of the first layer of glass; a second opening in the second layer of glass that extends from the first side of the second layer of glass to the second side of the second layer of glass, wherein an area of a third cross-section of the second opening at the first side of the second layer of glass is greater than an area of a fourth cross-section of the second opening at the second side of the second layer of glass; and wherein the first opening includes a first electrically conductive material and the second opening includes a second electrically conductive material, and wherein the first electrically conductive material and the second electrically conductive material are directly conductively coupled with each other.

Example 22 includes the package of example 21, wherein the first electrically conductive material or the second conductive material includes a selected one or more of: copper (Cu), aluminum (Al), or gold (Au).

Example 23 includes the package of examples 21 or 22, wherein the first electrically conductive material fills the first opening and the second electrically conductive material fills the second opening.

Example 24 includes the package of examples 21, 22, or 23, further comprising a first material in the first opening, wherein the first material is at least partially surrounded by the first electrically conductive material, or a second material in the second opening, wherein the second material is at least partially surrounded by the second electrically conductive material.

Example 25 includes the package of example 24, wherein the first material or the second material is a polymeric material.

Example 26 includes the package of examples 21, 22, 23, 24, or 25, wherein the first electrically conductive material and the second conductive material are direct bonded to each other.

Example 27 includes the package of examples 21, 22, 23, 24, 25, or 26, wherein the first layer of glass is direct bonded to the second layer of glass.

Example 28 includes the package of examples 21, 22, 23, 24, 25, 26, or 27, wherein the first cross-section or the second cross-section is a selected one or more of: a circle, a polygon, or an irregular shape.

Example 29 is a system comprising: an electrical component; a package coupled with the electrical component, the package comprising: a first layer of glass having a first side and a second side opposite the first side; a second layer of glass having a first side and a second side opposite the first side, wherein the second side of the first layer of glass is physically coupled with the first side of the second layer of glass; a first via that includes an electrically conductive material, wherein the first via extends from the second side of the first layer of glass to the first side of the first layer of glass; a second via that includes the electrically conductive material, wherein the second via extends from the first side of the second layer of glass to the second side of the second layer of glass, wherein the first via and the second via are conductively coupled with each other; and wherein the first via tapers from the second side of the first layer of glass to the first side of the first layer of glass, and wherein the second via tapers from the first side of the second layer of glass to the second side of the second layer of glass.

Example 30 includes the system of example 29, wherein an area of a first cross-section of the first via at the first side of the first layer of glass is less than an area of a second cross-section of the first via at the second side of the first layer of glass, wherein an area of a third cross-section of the second via at the first side of the second layer of glass is greater than an area of a fourth cross-section of the second via at the second side of the second layer of glass.

Example 31 includes the system of examples 29 or 30, wherein the electrically conductive material includes a selected one or more of copper or aluminum.

Example 32 includes the system of examples 29, 30, or 31, further comprising: a first material in the first via wherein the first material is at least partially surrounded by the electrically conductive material, or a second material in the second via wherein the second material is at least partially surrounded by the electrically conductive material; and wherein the first material or the second material is a polymeric material.

Example 33 includes the system of examples 29, 30, 31, or 32, wherein the first via and the second via are direct bonded to each other.

Example 34 includes the system of examples 29, 30, 31, 32, or 33, further comprising: a third layer of glass having a first side and a second side opposite the first side, wherein the third layer of glass includes a third via filled with the electrically conductive material, wherein the third via extends from the first side of the third layer of glass to the second side of the third layer of glass; wherein the first side of the third layer of glass is directly coupled with the second side of the second layer of glass; and wherein the third via is directly conductively coupled with the second via.

Example 35 includes the system of example 34, wherein the first via is direct bonded to the second via, wherein the second via is direct bonded to the third via, wherein the first layer of glass is direct bonded to the second layer of glass, and wherein the second layer of glass is direct bonded to the third layer of glass.

Example 36 is a method comprising: providing a first layer of glass having a first side and a second side opposite the first side; forming a first via in the first layer of glass, wherein the first via extends from the second side of the first layer of glass to the first side of the first layer of glass, wherein an area of a first cross-section of the first via at the first side of the first layer of glass is less than an area of a second cross-section of the first via at the second side of the first layer of glass; providing a second layer of glass having a first side and a second side opposite the first side; forming a second via in the second layer of glass, wherein the second via extends from the first side of the second layer of glass to the second side of the second layer of glass, and wherein an area of a third cross-section of the second via at the first side of the second layer of glass is greater than an area of a fourth cross-section of the second via at the second side of the second layer of glass; and bonding the second side of the first layer of glass to the first side of the second layer of glass.

Example 37 includes the method of example 36, wherein forming the first via in the first layer of glass further comprises filling the first via in the first layer of glass with an electrically conductive material; wherein forming the second via in the second layer of glass further comprises filling the second via in the second layer of glass with the electrically conductive material; and wherein bonding the second side of the first layer of glass to the first side of the second layer of glass further includes directly electrically coupling the filled first via with the filled second via.

Example 38 includes the method of examples 36 or 37, wherein bonding the second side of the first layer of glass to the first side of the second layer of glass further includes direct bonding the electrically conductive material of the first via and the electrically conductive material of the second via to each other.

Example 39 includes the method of examples 36, 37, or 38, wherein the electrically conductive material includes a selected one or more of: copper or aluminum.

Example 40 includes the method of examples 36, 37, 38, or 39, wherein bonding includes direct bonding and/or hybrid bonding.

## Claims

1. A package comprising:
a first layer of glass having a first side and a second side opposite the first side;
a second layer of glass having a first side and a second side opposite the first side, wherein the second side of the first layer of glass is physically coupled with the first side of the second layer of glass;
a first opening through the first layer of glass, wherein a size of the first opening at a first cross-section at the first side of the first layer of glass is less than a size of the first opening at a second cross-section at the second side of the first layer of glass;
a second opening through the second layer of glass, wherein a size of the second opening at a third cross-section at the first side of the second layer of glass is greater than a size of a fourth cross-section of the second opening at the second side of the second layer of glass; and
wherein the first opening includes a first electrically conductive material and the second opening includes a second electrically conductive material that are directly conductively coupled.

2. The package of claim 1, wherein the first electrically conductive material or the second conductive material includes a selected one or more of: copper (Cu), aluminum (Al), or gold (Au).

3. The package of claim 2, wherein the first electrically conductive material fills the first opening and the second electrically conductive material fills the second opening.

4. The package of claim 1, 2 or 3, further comprising a material in the first opening, wherein the material is at least partially surrounded by the first electrically conductive material.

5. The package of claim 1, 2, 3 or 4, wherein the material includes a polymeric material.

6. The package of claim 1, 2, 3, 4 or 5, wherein the first electrically conductive material and the second conductive material are direct bonded to each other.

7. The package of claim 6, wherein the first layer of glass is direct bonded to the second layer of glass.

8. The package of claim 1, 2, 3, 4, 5, 6 or 7, wherein the first cross-section or the second cross-section is a selected one or more of: a circle, a polygon, or an irregular shape.

9. A method comprising:
providing a first layer of glass having a first side and a second side opposite the first side;
forming a first via in the first layer of glass, wherein the first via extends from the second side of the first layer of glass to the first side of the first layer of glass, wherein a size of a first opening at a first cross-section of the first via at the first side of the first layer of glass is less than the size of a second opening at a second cross-section of the first via at the second side of the first layer of glass;
providing a second layer of glass having a first side and a second side opposite the first side;
forming a second via in the second layer of glass, wherein the second via extends from the first side of the second layer of glass to the second side of the second layer of glass, and wherein a size of a third opening at a third cross-section of the second via at the first side of the second layer of glass is greater than a size of a fourth opening at a fourth cross-section of the second via at the second side of the second layer of glass; and
bonding the second side of the first layer of glass to the first side of the second layer of glass.

10. The method of claim 9, wherein forming the first via in the first layer of glass further comprises filling the first via in the first layer of glass with an electrically conductive material;
wherein forming the second via in the second layer of glass further comprises filling the second via in the second layer of glass with the electrically conductive material; and
wherein bonding the second side of the first layer of glass to the first side of the second layer of glass further includes directly electrically coupling the filled first via with the filled second via.

11. The method of claim 10, wherein bonding the second side of the first layer of glass to the first side of the second layer of glass further includes direct bonding the electrically conductive material of the first via and the electrically conductive material of the second via to each other.

12. The method of claim 10 or 11, wherein the electrically conductive material includes a selected one or more of: copper or aluminum.

13. The method of claim 9, 10, 11 or 12, wherein bonding includes direct bonding and/or hybrid bonding.
